# EUROPEAN PATENT APPLICATION

(11) **EP 1 085 331 A2**
(43) Date of publication of application: **21.03.2001**
(21) Application number: 00119667.4
(22) Date of filing: 08.09.2000
(51) Int. Cl.: G01R 31/26

(54) **Semiconductor integrated circuit and method of measuring characteristics thereof**

(30) Priority: 14.09.1999 JP 26067799
(71) Applicant: NEC CORPORATION, Tokyo (JP)
(72) Inventor: Ohkawa, Shin-ichi, NEC Corporation, Minato-ku, Tokyo (JP)
(74) Representative: Betten & Resch

(57) **Abstract**

A semiconductor integrated circuit and a method for measuring the characteristics of a semiconductor integrated circuit are disclosed, which need the minimum test terminals for measuring the characteristics of a plurality of devices to be measured, so as to easily form the necessary terminals in a peripheral area of the chip, and which do not need an external control device for controlling the generation of the selection address signals. The semiconductor integrated circuit comprises elements to be measured (11); characteristic measurement terminals (13) for measuring the characteristics of the elements; and a control section for outputting a selection address signal for selectively connecting each element to be measured to the characteristic measurement terminals. Typically, the control section is a counter which is driven by a scanning signal used in the characteristic measurement and which automatically generates the selection address signal.

## Description

### BACKGROUND OF THE INVENTION

### Field of the Invention

The present invention relates to a semiconductor integrated circuit and method of measuring characteristics thereof, and more specifically, to a semiconductor integrated circuit having terminals for characteristic measurement, and a plurality of elements to be measured whose characteristics are measured via the terminals, and a method of measuring characteristics thereof.

### Description of the Related Art

Conventionally, a semiconductor integrated circuit having a plurality of elements to be measured (i.e., elements whose characteristics need to be checked) and terminals for measurement of characteristics is known. The structure of such a semiconductor integrated circuit is used for measuring the characteristics of a TEG (test element group), a dedicated chip only used for tests, and of a chip as a finished product.

In the case of finished products, in addition to a semiconductor device formed in a center area of the chip, a plurality of elements to be measured are formed in the peripheral area thereof. The elements to be measured include various kinds of devices such as transistors and circuits for forming semiconductor devices, and the distribution of the characteristics of each element to be measured can be determined by performing a test in which the characteristics of the elements are measured.

That is, it is examined whether the variation in the characteristics of each device, circuit, and the like satisfies a desired specification, or the spread of the distribution of characteristics is determined, so as to assure the characteristics of each device or circuit and secure reliability.

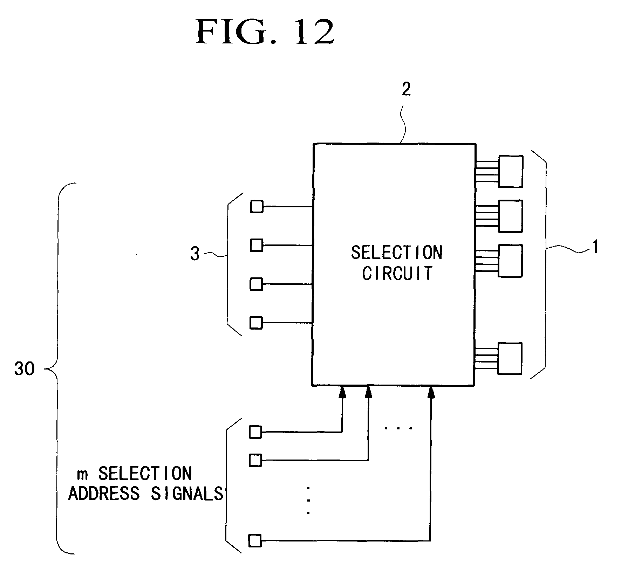

Fig. 12 is a block diagram showing devices to be measured of a conventional semiconductor integrated circuit. As shown in the figure, n devices 1 to be measured, provided in the conventional semiconductor integrated circuit, are connected via selection circuit 2, to, for example, a set of four terminals 3 for measuring the characteristics (i.e., characteristic measurement terminals).

Here, m selection address signals are input into the selection circuit 2, thereby selecting any one 2^{m} devices to be measured (n≦2^{m}). The characteristic measurement terminals 3 are connected to pads which are formed in the chip (not shown) on which these devices 1 to be measured are mounted).

The characteristic measurement terminals 3 and terminals for inputting the selection address signals form test terminal 30.

In the evaluation of the characteristics of the devices 1, one of the devices (here, n devices) 1 to be currently evaluated is selected using the selection address signals, and the probe is made to make contact with each relevant pad. In this process, according to the selection address signals, the selection circuit 2 electrically connects the device to be currently evaluated to the set of characteristic measurement terminals by using a MOS (metal oxide semiconductor) transistor switch or the like.

Japanese Unexamined Patent Application, First Publication, No. Hei 4-128668 discloses such a semiconductor integrated circuit. This disclosed circuit comprises an address decoding circuit for receiving a plurality of selection address signals and outputting a decoding signal, a gate voltage output switching circuit for receiving the decoding signal and switchably outputting a gate voltage used for measurement, and a plurality of MOS transistors to be measured, in which each gate receives the gate voltage (switchably output) and each source and each drain are respectively connected to a common source terminal and a common drain terminal.

Therefore, a transistor to be measured is selected from among a plurality of transistors having different check patterns by using the selection address signals sent via the external output terminals, thereby measuring threshold voltage values of a plurality of adjacent check patterns and correctly determining the distribution of the threshold voltage.

However, when a plurality of devices are measured in the above conventional semiconductor integrated circuit, each device is selected in turn by independently providing the selection address signals. Therefore, a larger number of test terminals 30 are necessary. That is, as dedicated selection address signals are necessary for selecting each device to be measured, the number of the selection address signals increases according to the increase in the number of the devices to be measured.

If the selection circuit 2 for performing selection between 2^{m} devices 1 to be measured is provided, the circuit to be connected to the relevant device 1 must be switched according to the designated address; thus, it is necessary to input the selection address signals corresponding to the execution number of the switching operation. The number of terminals for inputting the necessary signals is (i) (2⁷ =) 128 when the number of devices 1 to be measured is 100, and (ii) (2¹⁰ =) 1024 when the number of devices 1 to be measured is 1000.

Such an increase in the number of the test terminals 30 makes the forming of each terminal difficult or impossible because the terminals 30 are formed in a small peripheral area of the chip. Additionally, in addition to a parameter analyzer and the like used for the measurement, an external control device such as a computer for controlling stepping generation of the selection address signals is necessary in the measurement.

### SUMMARY OF THE INVENTION

In consideration of the above circumstances, an objective of the present invention is to provide a semiconductor integrated circuit and method for measuring the characteristics of a semiconductor integrated circuit, which require a minimum number of test terminals for measuring the characteristics of a plurality of devices to be measured, so as to easily form the necessary terminals in a peripheral area of the chip, and which do not need an external control device for controlling the generation of the selection address signals.

Therefore, the present invention provides a semiconductor integrated circuit comprising elements to be measured; characteristic measurement terminals for measuring the characteristics of the elements; and a control section for outputting a selection address signal for selectively connecting each element to be measured to the characteristic measurement terminals.

Typically, the control section is a counter which is driven by a scanning signal used in the characteristic measurement and which automatically generates the selection address signal.

According to the above structure, when a selection address signal (or signals) is output from the control section, one of the elements to be measured is selectively connected to the selection address signals. Accordingly, the minimum number of test terminals (i.e., only the necessary characteristic measurement terminals) are necessary, so that the necessary terminals can be easily formed in a peripheral area of the relevant chip, and no external control device for controlling the generation of the selection address signal is necessary.

The present invention also provides a method of measuring the characteristics of a semiconductor integrated circuit comprising elements to be measured and characteristic measurement terminals for measuring the characteristics of the elements, the method including the steps of selectively connecting each element to be measured to the characteristic measurement terminals; and measuring the characteristics of said element via the characteristic measurement terminals.

### BRIEF DESCRIPTION OF THE DRAWINGS

Fig. 1 is a block diagram showing the general structure of an embodiment of the semiconductor integrated circuit according to the present invention.
Fig. 2 is a diagram showing a standard pattern of the characteristic measurement pads.
Fig. 3 is a graph showing an example of the characteristics obtained by the measurement.
Figs. 4A and 4B show a specific example of the semiconductor integrated circuit as shown in Fig. 1, where Fig. 4A shows the basic circuit while Fig. 4B shows a circuit including a plurality of elements to be measured, connected to each other.
Figs. 5A to 5D are diagrams for explaining the switching operation of the circuit example as shown in the Figs. 4A and 4B, where Figs. 5A to 5C shows examples of the switch, while Fig. 5D is a waveform diagram explaining generation of a switching operation signal.
Fig. 6 is a diagram showing another specific example of the semiconductor integrated circuit as shown in Fig. 1.
Fig. 7 is a diagram showing another specific example of the semiconductor integrated circuit as shown in Fig. 1.
Fig. 8 is a diagram showing an example of the counter circuit of the circuit example of Fig. 7.
Fig. 9 is a graph explaining the reset timing of the counter circuit of Fig. 8.
Fig. 10A is a diagram showing four flip-flop circuits of the counter circuit of Fig. 8, and Fig. 10B is a timing chart explaining the operation of the counter circuit of Fig. 8.
Fig. 11 is a flowchart explaining the operation of the embodiment of the semiconductor integrated circuit.
Fig. 12 is a block diagram showing devices to be measured in a conventional semiconductor integrated circuit.

### DESCRIPTION OF THE PREFERRED EMBODIMENTS

Hereinafter, embodiments according to the present invention will be explained in detail with reference to the drawings.

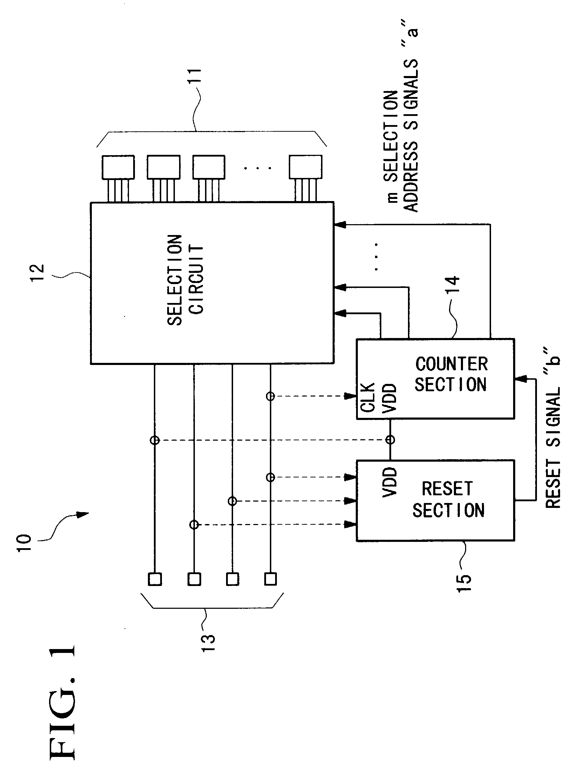

Fig. 1 is a block diagram showing the general structure of an embodiment of the semiconductor integrated circuit according to the present invention. As shown in Fig. 1, semiconductor integrated circuit 10 comprises n devices to be measured (i.e., a plurality of elements to be measured) 11, selection circuit 12, a set of characteristic measurement terminals 13 (for example, 4 terminals), counter section (corresponding to the control section of the present invention) 14, and reset section 15.

The n devices 11 to be measured are connected via the selection circuit 12 to the characteristic measurement terminals, and m selection address signals "a" are input from counter section 14 to which reset signal "b" is input from the reset section. The selection circuit 12 selectively connects each device 11 to be measured to the characteristic measurement terminals 13 according to the input selection address signals "a", so that any one of 2^{m} devices 11 to be measured can be selected (n≦2^{m}) .

The semiconductor integrated circuit 10 having the above structure can be applied to, for example, TEG, a chip dedicatedly used for the tests. In such a chip, elements to be measured such as devices 11 are formed. The elements to be measured include various kinds of devices such as transistors and circuits for forming semiconductor devices, and the distribution of the characteristics of each element to be measured can be determined by measuring the characteristics of the elements.

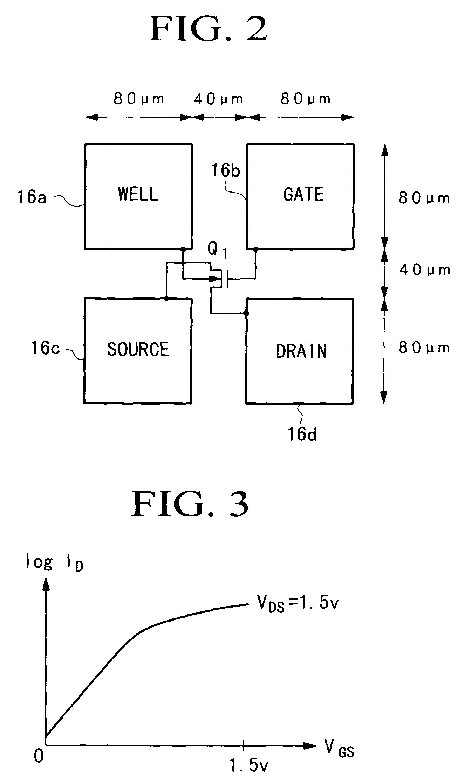

The measurement of the characteristics is performed by making a probe make contact with each relevant pad (see Fig. 2). The pads are formed in the chip (not shown) in which the devices 11 to be measured are formed, and are connected to the characteristic measurement terminals 13.

In the evaluation of the characteristics of each element to be measured, one of the devices (here, n devices) 11 to be currently evaluated is selected using the selection address signals "a". Here, the selection address signals "a" are automatically generated by the counter section 14 provided in the chip, and the selection circuit 12 electrically connects the device to be currently evaluated to the set of characteristic measurement terminals 13 according to the selection address signals "a", by using a MOS (metal oxide semiconductor) transistor switch or the like. That is, the target device 11 to be measured and the characteristic measurement terminals 13 are selectively connected according to the input selection address signals "a".

The drive signal for driving the counter section 14 is input through a dedicated terminal, or a scanning signal used in the measurement can also be used as the drive signal. The power source for the counter section 14 may be supplied using a dedicated power supply terminal, or using one of the measurement signals which has a fixed bias.

If the counter section 14 must be reset, the resetting operation can be performed by using (i) a reset circuit which is connected to a dedicated terminal for driving the counter or to the characteristic measurement terminals 13, and which has a threshold value outside the amplitude range of the usual counting signal or outside the usual scanning range of the measurement using the measurement terminals, (ii) a sequence of applying voltage to a dedicated terminal for driving the counter or to the characteristic measurement terminals 13, or (iii) a circuit for generating a one shot pulse when the voltage is applied.

Fig. 2 is a diagram showing a standard pattern of the characteristic measurement pad. As shown in the figure, the well, gate, source, and drain of transistor Q to be measured are respectively connected to four pads 16a, 16b, 16c, and 16d.

Each pad (16a, 16b, 16c, and 16d) has a 80 µm × 80 µm rectangular surface, and four pads are arranged in a 2 × 2 matrix shape as shown in Fig. 2, where each gap between the adjacent pad surfaces is 40 µm. This is a standard pattern as the 4-point pad used for the auto probe, where the probe is made in contact with each pad.

Fig. 3 is a graph showing an example of the characteristics obtained by the characteristic measurement. That is, according to the normal measurement, the characteristic result as shown in Fig. 3 is obtained. Fig. 3 shows a result for a case using a fixed parameter of drain-source voltage V_{DS} = 1.5V, where the horizontal axis shows the gate-source voltage V_{GS}, and the vertical axis shows the drain current I_{D}.

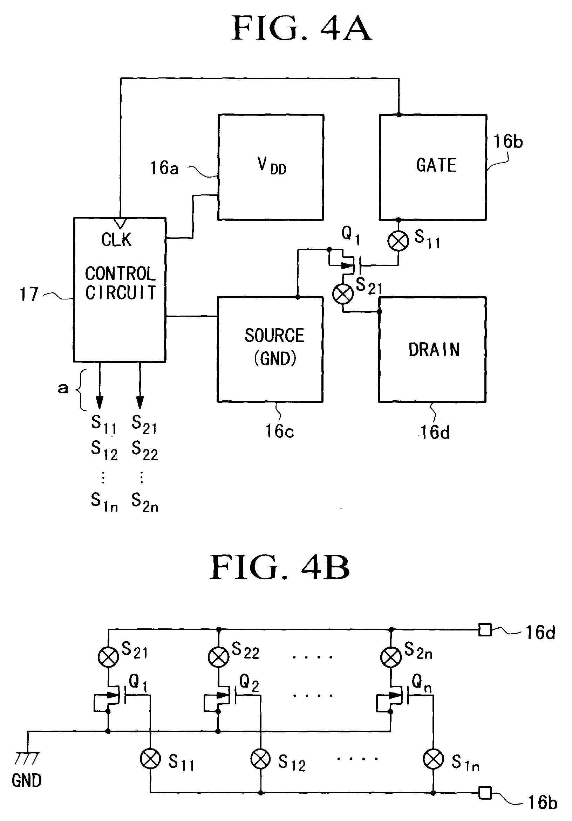

Figs. 4A and 4B show a specific example of the semiconductor integrated circuit as shown in Fig. 1. Fig. 4A shows the structure of the basic circuit, while Fig. 4B shows a structure including a plurality of transistors connected to each other.

As shown in Fig. 4A, the gate of transistor Q to be measured is connected via switch S₁₁ to pad 16b, the source of transistor Q is connected to pad 16c, and the drain of transistor Q is connected via switch S₂₁ to pad 16d.

In addition, pads 16a, 16b, and 16c are connected to control circuit 17. Pad 16a functions as a source voltage V_{DD} terminal, pad 16b functions as a gate terminal, pad 16c functions as a source (GND) terminal, and pad 16d functions as a drain terminal. In this example, the electric potential of the well is the same as that of the source. The control circuit 17 outputs selection address signals "a" functioning as a control signal for performing switching operation of switch S₁₁ or S₂₁.

When a plurality of transistors Q (Q₁, Q2. ..., Qₙ) to be measured are connected as shown in Fig. 4B, the gate of each transistor Q is connected via switches S₁₁,S₁₂, ..., S₁ₙ to pad 16b as the gate terminal, and the drain of each transistor Q is connected via switches S₂₁, S₂₂, ..., S₂ₙ to pad 16d, and the source of each transistor Q is connected to the GND.

In this case, the state of each of the switches S₁₁, S₁₂, ..., S₁ₙ, and the switches S₂₁, S₂₂, ..., S₂ₙ is switched according to the control signal output from the control circuit 17, so as to select transistor Q to be currently measured.

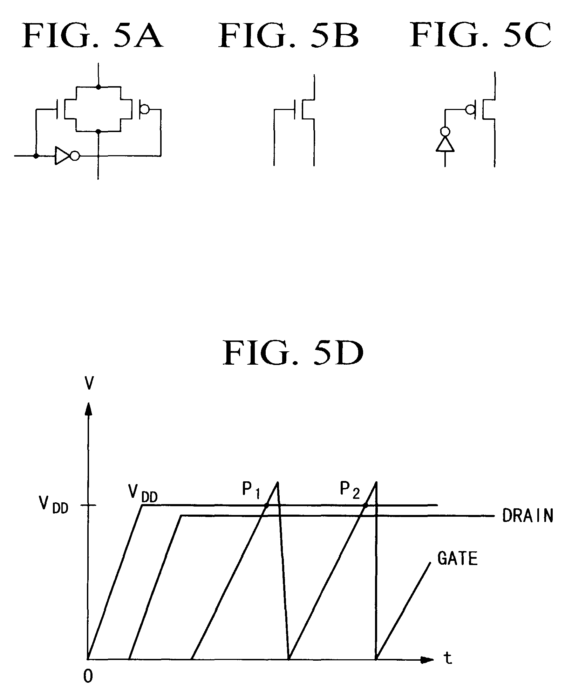

The switching operation of the specific example shown in Figs. 4A and 4B will be explained with reference to Figs. 5A to 5D. Figs. 5A to 5C show examples of the switches, while Fig. 5D shows waveforms for explaining the generation of a switching operation signal. Switches using p-channel MOS transistor(s) and/or inverter(s), as shown in Figs. 5A to 5C, can be used in the specific example shown in Figs. 4A and 4B. The control circuit 17 generates a switching operation signal (for performing the switching operation) by gradually changing the gate voltage (see Fig. 5D) so as to trigger when the gate voltage exceeds a threshold value. If the threshold value is the source voltage V_{DD}, the trigger occurs at each of measurement points P₁, P₂, ...

It is not always necessary to switch both of the above switches S₁₁, S₁₂, ..., S₁ₙ, and the switches S₂₁, S₂₂, ..., S₂ₙ. When using MOS transistors, only the switches connected to the drain must be switched, that is, a switching operation of only one of both kinds of switches is necessary. When using bipolar transistors, both kinds of transistors, connected to the base and the collector, must be switched.

Accordingly, either of MOS and bipolar transistors can be used, where when using bipolar transistors, three terminals of emitter, base, and collector are used.

Therefore, the switches S₁₁, S₁₂, ..., S₁ₙ, and the switches S₂₁, S₂₂, ..., S₂ₙ function as a selection circuit (refer to Fig. 1) for switching the element to be measured, and the control circuit 17 functions as counter section 14 for generating and outputting the selection address signals "a" for operating the switches and as reset section 15 (also refer to Fig. 1).

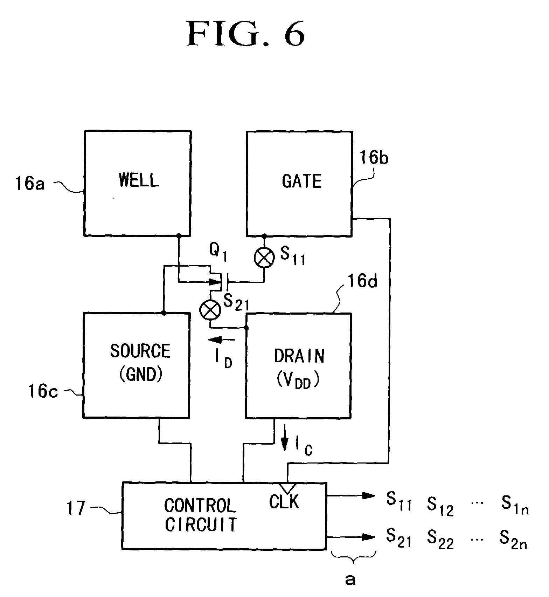

Fig. 6 is a diagram showing another specific example of the semiconductor integrated circuit shown in Fig. 1. As shown in the figure, in this example, the drain and the source voltage V_{DD} are common, and the well can be separately measured. The current I_{C} flowing into the control circuit 17 is sufficiently smaller than drain current I_{D} (I_{C} << I_{D}). The other structural elements are the same as those of the basic circuit as shown in Fig. 4A.

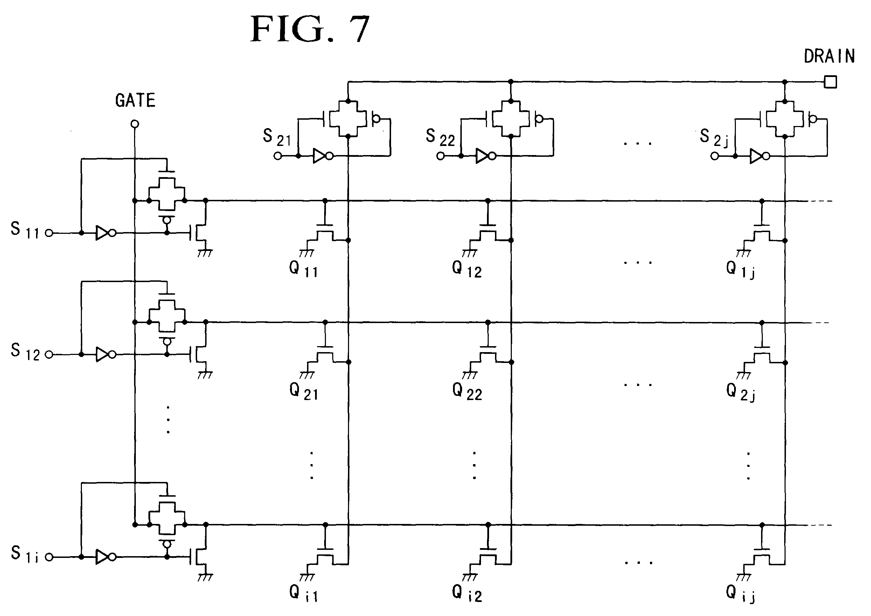

Fig. 7 is a diagram showing another specific example of the semiconductor integrated circuit shown in Fig. 1. As shown in the figure, in this example, a plurality of transistors to be measured (Q₁₁, Q₁₂, ..., Q₁ⱼ, Q₂₁, Q₂₂, ..., Q₂ⱼ, ... and Qᵢ₁, Qᵢ₂, ..., Qᵢⱼ) are arranged in a matrix form which may be used for the arrangement for the memory-cell selection.

According to such a matrix-form arrangement of transistors, one of the transistors can be efficiently selected even if the number of transistors increases. That is, in the circuit arrangement as shown in Fig. 4A, the number of switches S increases in proportion to the number of the transistors, which may cause (i) an increase in the processed area, that is, the chip area, or (ii) the generation of noises or leakage current imposed on the switches S, which causes an error. Such problems can be solved using the structure shown in Fig. 7.

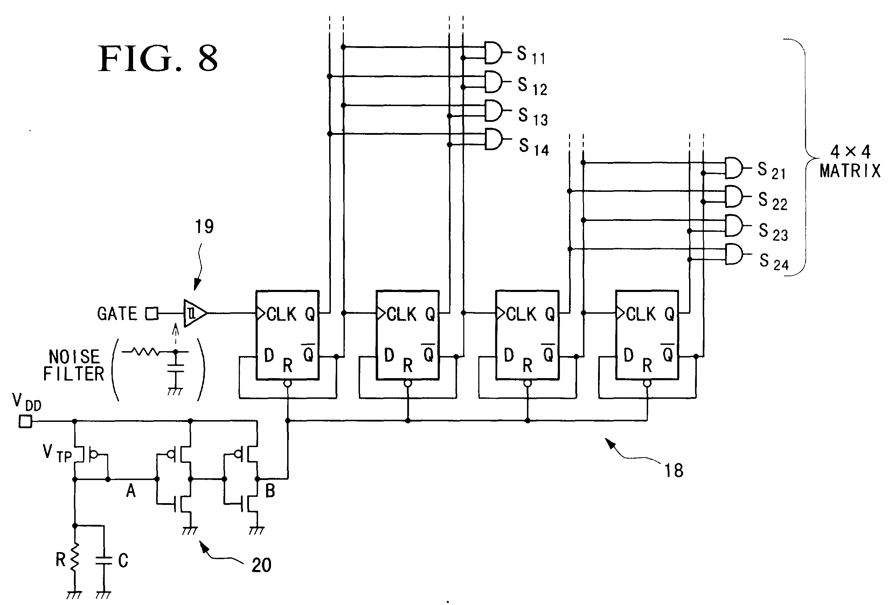

Fig. 8 is a diagram showing an example of the counter circuit applied to the circuit example of Fig. 7. When a plurality of transistors are arranged in a matrix form, counter circuit 18 using a flip-flop structure may be used, as shown in Fig. 8. The counter circuit 18, connected via an ordinary differential comparator 19 or the like to the pad of the gate terminal, generates and outputs selection data for selecting one of the transistors arranged in a 4 × 4 matrix form. The operation of resetting the counter circuit 18 is performed using the rising timing of the source voltage V_{DD}.

When a measurement scanning signal is used for driving the counter circuit 18, a comparator circuit having a threshold value in the vicinity of the scan-end point of a necessary scanning range can be used, and the comparator circuit preferably has the Schmidt characteristics in which the threshold value is decreased if the signal intensity exceeds the threshold value (i.e., crosses from the lower-value side), or the threshold value is increased if the signal intensity becomes smaller than the threshold value (i.e., crosses from the upper-value side). Accordingly, the circuit operation can be stable. In addition, such a comparator circuit may include a simple noise filter having a capacitor (capacity) C, a resistor (resistance) R, and the like (refer to Fig. 8).

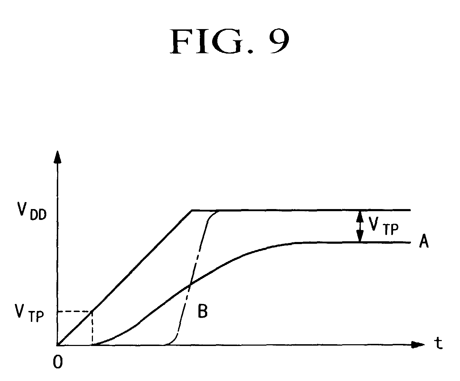

Fig. 9 is a graph for explaining the reset timing of the counter circuit of Fig. 8. As shown in Fig. 9, after the source voltage V_{DD} exceeds threshold voltage V_{TP} determined by V_{DD,} that is, the threshold value of the relevant p-channel transistor, the voltage of point A (see Fig. 8) gradually increases. If it is assumed that the threshold value of inverter 20 is approximately half the source voltage V_{DD}, point B (see Fig. 8) becomes active when the voltage of point A exceeds approximately half the source voltage V_{DD}.

That is, a timing signal is output when the voltage of a target point exceeds a fixed voltage, and the counter circuit can be reset using the timing signal. The operation of points A and B depends on the values of capacitor C and resistor R, and on the rising speed of the source voltage V_{DD}.

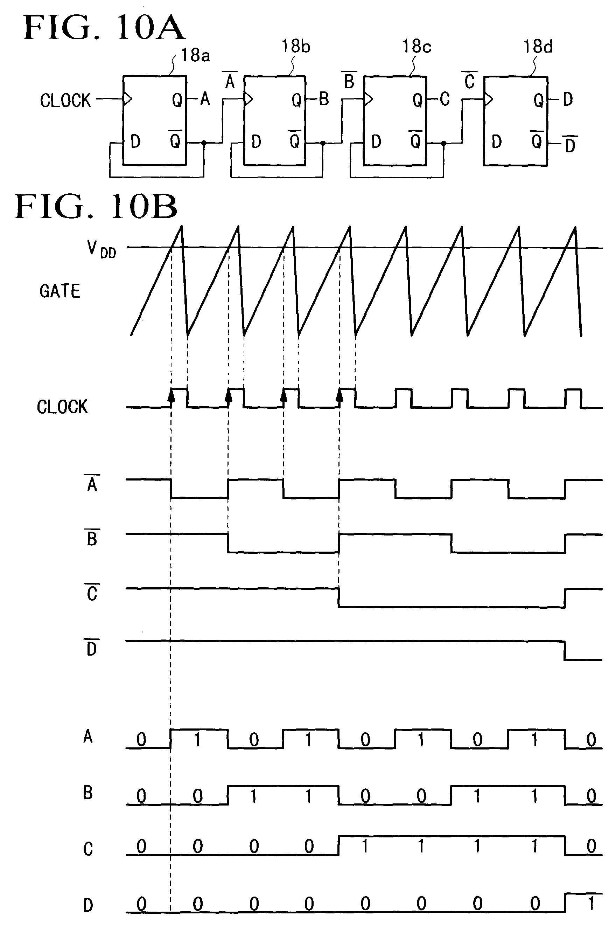

Fig. 10B is a timing chart explaining the operation of the counter circuit of Fig. 8. When a gate waveform is input into each of four flip-flop circuits 18a, 18b, 18c, and 18d as shown in Fig. 10A, a clock pulse signal is generated and divided so as to form the waveform of each point, and signals corresponding to each of 2^{m} bits are output. The output signals are input into the array-type selection circuit 12, thereby one of the transistors to be currently measured can be selected.

Basically, the flip-flop circuits are operated using the rising edge of the clock signal which is output when the gate voltage crosses the source voltage V_{DD}, thereby executing the counting operation. That is, the change of the gate voltage is used for the counting operation, and the measurement is executed using the increase of the gate voltage. After the current measurement, the operation necessary for measuring the next device (transistor Q) to be measured is performed.

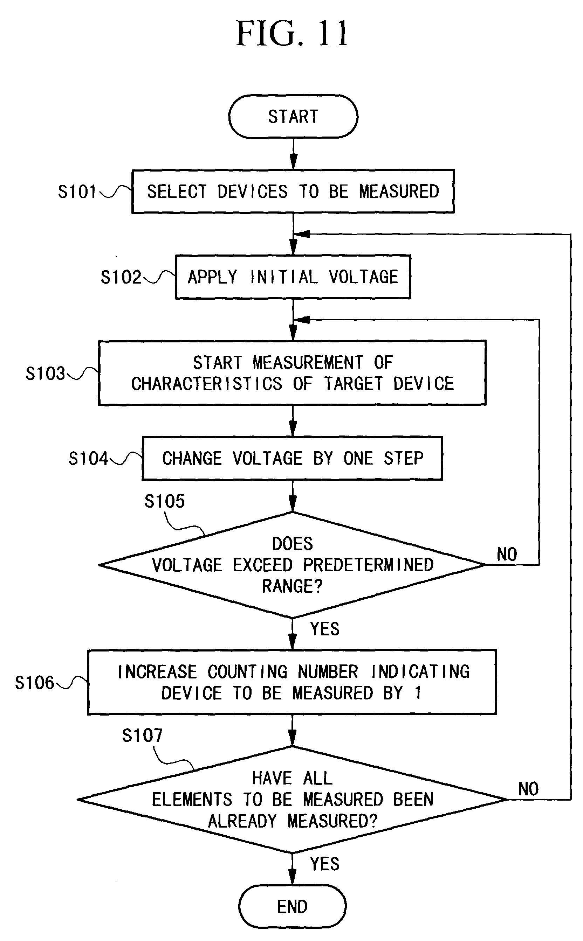

Fig. 11 is a flowchart showing the operation of the semiconductor integrated circuit of the present embodiment. As shown in the figure, first, a set of devices to be measured (i.e., elements to be measured) is selected from a plurality of groups (see step S101). Here, a set of pads provided in the chip is selected, and the probe is made to make contact with each pad.

Next, the initial voltage is applied (see step S102). For example, in the basic circuit as shown in Fig. 4A, the initial voltage applied to the source is 0V, 1.5V is applied to the drain and source voltage V_{DD}, while the initial voltage applied to the gate is 0V. According to the application of the initial voltage to the selected devices, measurement of the drain-source current I_{DS} of the target device is started (see step S103).

Next, the gate voltage is increased by one-step range (for example, 0.05 V), that is, the voltage is changed by one step (see step S104). According to the change, it is determined whether the voltage exceeds a predetermined range (see step S105). The determination is performed by comparing the gate voltage with the predetermined range (here, 1.5V), or by comparing the execution number of the measurement with the predetermined number (1.5 / 0.05 = 30).

If the result of the determination is "No^{"}, that is, if the relevant voltage does not exceed the predetermined range, the operation returns to step S103, while if the voltage exceeds the predetermined range (i.e., the result is "Yes"), then the counting number indicating the device to be currently measured is increased by 1 (see step S106).

In the next step, it is determined whether all the target elements (i.e., devices) have been measured (see step S107). If all the target devices have not yet been measured (i.e., "No"), the operation returns to step S102, while if all the target devices have been measured (i.e., "Yes"), that is, if the counting number is larger than the upper limit of the number of the devices to be measured, the operation is completed.

The circuit is suitably designed so that the range of the voltage referred to in the above determination can be predetermined. The upper limit of the number of elements to be measured may be predetermined, or an external device having a counter for counting the number of the elements to be measured may be provided so as to execute compulsory completion.

The circuit for automatically executing the above-explained operation, that is, the control circuit 17 is mounted on the semiconductor integrated circuit 10 in the chip. Therefore, the characteristics of a set of (many) devices to be measured can be continuously measured without moving the probe on the pad 16. The probe is moved when the element to be measured is changed from the current set to the next set.

That is, according to the semiconductor integrated circuit 10, a plurality of (infinite, in principle) devices, whose characteristics are to be checked, can be measured using a small number (3 or 4) of terminals. The selection address signals "a" are automatically generated using an internal counter, and the scanning signal for the measurement also functions as the increment signal of the counter, thereby simply measuring the characteristic distribution between the devices using a conventional measurement device such as a parameter analyzer. In addition, the threshold value of the clock input of the counter (relating to the Schmidt characteristics) is set in the vicinity of the scan-end point of the measurement signal, and accordingly, when the measurement of the current device is over, the device to be measured is automatically switched to the next device.

According to the present invention, when the characteristics of the TEG devices are evaluated, or when the chip as a finished product is evaluated, each of the devices 11 to be measured can be selectively connected to a set of characteristic measurement terminals 13. In this process, the address signals for selecting the target device is automatically generated by the internal counter, and the selective connection between the target device 11 to be measured and the characteristic measurement terminals 13 is performed using the MOS transistor switches.

The scanning signal used in the measuring operation functions as the (clock) signal for driving the counter. A dedicated power source may be used for the counter, or a measurement signal having a fixed bias may also be used for providing the power. If the counter must be reset, (i) a reset determination circuit having a threshold value outside the ordinary scanning range may be connected to the characteristic measurement terminals 13, (ii) the sequence of applying voltage to the characteristic measurement terminals 13 may be used, or (iii) a circuit for generating a one shot pulse at the time of applying voltage may be provided.

Therefore, the distribution of the characteristics between a plurality of devices can be measured without increasing the number of terminals, that is, by using 3 to 4 terminals provided for the conventional pattern for checking the characteristics of the devices. Accordingly, the number of terminals necessary for the measurement is 4 or less (3 if the well is fixed), and thus it is possible and easy to form terminals in a small peripheral area (in which devices to be measured are provided) of the relevant chip.

As the chip area can be as small as possible, the number of chips formed on a single wafer can be as large as possible while the area necessary for setting the probe on the pads is secured. Here, even after the chip is packaged, internal measurement is possible if at least four external terminals are formed for supplying the selection address signals.

In addition, any signal through a provided terminal (which can be conveniently used) is also used as a counter signal or a reset signal so as to automatically and internally execute the resetting and counting operations. Accordingly, the target device to be measured can be automatically switched using a conventional measurement sequence performed using a parameter analyzer or the like.

In this case, it is unnecessary to input selection address signals from an external device. Therefore, it is also unnecessary to use a control device such as a computer for step-like generating the selection address signals. Conventionally, such a device is necessary when a parameter analyzer or the like is used. That is, it is unnecessary to use a dedicated device for generating the selection address signals.

In addition, the counter can be reset using the sequence of applying voltage, thereby omitting a dedicated reset terminal.

Recently, the size of the devices to be measured has become smaller, and the distribution measurement using a larger number of samples is required. According to the present invention, efficient measurement can be performed under such a situation. More specifically, in a small device, for example, having a gate length L of 0.15 to 0.1 µm and a gate width W of 0.3 to 0.2 µm, it is difficult to accurately adjust the gate width W and gate length L, and variation in the concentration of impurities or the like tends to be explicit, and thus the necessity of the distribution (or variation) measurement increases.

According to the present invention, the device to be measured can be switched using a measurement signal; thus, the present technique can also be used for, for example, the measurement of the offset voltage of a differential pair of devices for analog use. The element to be measured is not limited to a single device such as a transistor or a resistor, but may be a unit circuit of a basic circuit such as a differential amplifier or an A/D converter, or of a circuit module.

In such a case, the number of terminals is not limited to 4, but a smaller or larger number of terminals may be used. In addition, the signal for switching the target device to be measured is generated by using a measurement signal; thus, dedicated selection address signals are unnecessary.

Furthermore, if the number of the devices to be selected and measured agrees with the number of selection address signals, the counter resetting operation is unnecessary.

## Claims

1. A semiconductor integrated circuit comprising:
elements to be measured (11);
characteristic measurement terminals (13) for measuring the characteristics of the elements; and
a control section (14) for outputting a selection address signal for selectively connecting each element to be measured to the characteristic measurement terminals.

2. A semiconductor integrated circuit as claimed in claim 1, wherein the control section is a counter which is driven by a scanning signal used in the characteristic measurement and which automatically generates the selection address signal.

3. A semiconductor integrated circuit as claimed in claim 2, comprising a comparator circuit having the Schmidt characteristics in which the threshold value is set in the vicinity of the scan-end point of a predetermined scanning range of the scanning signal.

4. A semiconductor integrated circuit as claimed in claim 3, wherein a noise filter is connected to the comparator circuit so as to prevent an erroneous operation caused by a noise occurring in the measurement.

5. A semiconductor integrated circuit as claimed in claim 2, wherein a resetting operation of the counter is performed by using a reset circuit which is connected to a dedicated terminal for driving the counter or to the characteristic measurement terminals, and which has a threshold value outside the amplitude range of a usual counting signal or outside a usual scanning range of the measurement using the characteristic measurement terminals.

6. A semiconductor integrated circuit as claimed in claim 2, wherein a resetting operation of the counter is performed by using a sequence of applying a voltage to a dedicated terminal for driving the counter or to the characteristic measurement terminals.

7. A semiconductor integrated circuit as claimed in claim 2, wherein a resetting operation of the counter is performed by using a circuit for generating a one shot pulse at the time of applying a voltage.

8. A semiconductor integrated circuit as claimed in one of claims 1 to 7, wherein the connection between each element to be measured and the characteristic measurement terminals is performed by a switching operation using a MOS transistor.

9. A semiconductor integrated circuit as claimed in one of claims 1 to 8, wherein the number of the characteristic measurement terminals is 3 or 4.

10. A method of measuring the characteristics of a semiconductor integrated circuit comprising elements to be measured and characteristic measurement terminals for measuring the characteristics of the elements, the method including the steps of:
selectively connecting each element to be measured (11) to the characteristic measurement terminals (13); and
measuring the characteristics of said element via the characteristic measurement terminals.

11. A method of measuring the characteristics of a semiconductor integrated circuit as claimed in claim 10, wherein the step of selectively connecting each element to be measured to the characteristic measurement terminals is performed by using a selection address signal generated by a counter which is driven by a scanning signal used in the characteristic measurement.

12. A method of measuring the characteristics of a semiconductor integrated circuit as claimed in claim 11, wherein the threshold value is set in the vicinity of the scan-end point of a predetermined scanning range of the scanning signal.
